# EUROPEAN PATENT APPLICATION

(11) **EP 1 736 268 A2**
(43) Date of publication of application: **27.12.2006**
(21) Application number: 06011947.6
(22) Date of filing: 09.06.2006
(51) Int. Cl.: B23H 9/00, H01L 21/304

(54) **Method of working nitride semiconductor crystal**

(30) Priority: 24.06.2005 JP 2005184367; 22.03.2006 JP 2006079063
(71) Applicant: Sumitomo Electric Industries, Ltd., Osaka-shi, Osaka 541-0041 (JP)
(72) Inventor: Ishibashi, Keiji, Itami-shi Hyogo 664-8611 (JP); Hachigo, Akihiro, Itami-shi Hyogo 664-8611 (JP); Nishiura, Takayuki, Itami-shi Hyogo 664-8611 (JP)
(74) Representative: Grünecker, Kinkeldey, Stockmair & Schwanhäusser Anwaltssozietät

(57) **Abstract**

In a method of working a crystal, when a nitride semiconductor crystal (1) is worked, voltage is applied between the nitride semiconductor crystal (1) and a tool electrode (3) to cause electrical discharge, so that the crystal is partially removed and worked by local heat generated by the electrical discharge.

## Description

### BACKGROUND OF THE INVENTION

### Field of the Invention

The present invention relates to a method of working a semiconductor crystal, and more particularly to a method of working a nitride semiconductor crystal.

### Description of the Background Art

Generally, a cutting tool such as an inner diameter blade or a wire saw is used to cut out a substrate from a semiconductor crystal ingot of silicon or the like. A compound semiconductor crystal ingot of GaAs, InP or the like is also cut with a multi-wire saw, as described in Japanese Patent Laying-Open No. 09-017755, for example.

Among compound semiconductors, a nitride semiconductor crystal of GaN or the like has a wide energy band gap, and thus it is in increasing demand as a semiconductor suitable for an LED (light emitting diode) or an LD (laser diode) capable of emitting short-wavelength light. Accordingly, it is desired to work a grown crystal ingot of a nitride semiconductor in a simple and efficient manner at lower costs.

However, since the nitride semiconductor crystal of GaN or the like among the compound semiconductors has high hardness and low toughness, it is difficult to cut such a nitride crystal by the same apparatus and method as those used for a Si crystal or a GaAs crystal, and there often arise problems such as crack generation and waviness on a surface formed by cutting (hereinafter referred to as a cut-surface). Specifically, since the GaN crystal has low toughness, it is liable to cause cracks or fracture. Further, since the GaN crystal has high hardness and is composed of two elements, distortion due to cutting easily occurs depending on distribution of hardness in the crystal. In order to cut a GaN ingot with a good yield rate, therefore, it is necessary to reduce cutting load, which may cause reduction in throughput.

Furthermore, during growth of the semiconductor crystal ingot, a polycrystalline portion (a portion having low crystalline quality) grows in a peripheral region of the semiconductor ingot. Although this peripheral region should be removed, grinding the periphery of the nitride semiconductor ingot is liable to cause cracks. When the ingot is long, it is also difficult to work the long ingot with a core drill, resulting in severe wear of the tool. Further, since such working needs abrasive grains and a grinding wheel, it requires higher costs. Specifically, residual stress is concentrated in the polycrystalline portion in the peripheral region of the GaN ingot, and thus if balance of the stress is lost during the working, cracks are spontaneously generated due to poor strength of the crystal. Furthermore, when the core drill is used to work the long ingot, it is difficult for a working fluid to permeate through a position to be worked, whereby making it difficult to provide satisfactory working.

### SUMMARY OF THE INVENTION

In view of the situation of the conventional art as described above, an object of the present invention is to provide a technique capable of working a nitride semiconductor crystal in a simple and efficient manner at lower costs.

In a method of working a nitride semiconductor crystal according to the present invention, when the nitride semiconductor crystal is worked, voltage is applied between the crystal and a tool electrode to cause electrical discharge, so that the crystal is partially removed and worked by local heat generated by the electrical discharge.

The nitride semiconductor crystal can be cut using a wire electrode as the tool electrode. Preferably, the wire electrode is made of tungsten or molybdenum. In such a manner, a nitride semiconductor crystal substrate can be obtained by cutting an ingot of the nitride semiconductor crystal. Further, after cutting the nitride semiconductor crystal, a cut-surface of the crystal can be smoothed by sweeping the cut-surface again with the wire electrode. On the other hand, the nitride semiconductor crystal substrate obtained by the cutting may further be etched. In addition, the nitride semiconductor crystal substrate obtained by the cutting may further be polished.

Furthermore, while a peripheral region of the nitride semiconductor crystal ingot includes a portion having low crystalline quality as compared to an inside region of the ingot, the ingot including the portion of low crystalline quality can be cut in a direction perpendicular to a direction in which the ingot has grown. Further, unevenness on a grown surface of the nitride semiconductor crystal ingot can be removed to obtain an ingot having a surface with unevenness of less than 30 µm.

With the cutting method according to the present invention, the nitride semiconductor crystal ingot can be cut so as to separate a peripheral portion thereof having low crystalline quality from a good crystal portion inside the ingot. More specifically, a through-hole is formed in the nitride semiconductor ingot and then the wire electrode is passed through the through-hole to make the through-hole a starting point for cutting in order to take out a good crystal inside the ingot without working the peripheral portion having low crystalline quality. With the working method according to the present invention, an edge at an end of a surface of the nitride semiconductor crystal can also be removed by inclining a longitudinal direction of the wire electrode at an angle in a range of 0-60° from a direction perpendicular to the surface of the nitride semiconductor crystal.

Further, a desired surface geometry can be formed on the nitride semiconductor crystal by transferring a surface geometry of the tool electrode to the crystal. Furthermore, unevenness on a surface of the nitride semiconductor crystal can be removed to obtain a smooth surface having a surface roughness Ry of less than 10 µm and a flatness of less than 20 µm, by using the tool electrode having a surface roughness Ry of less than 10 µm and a flatness of less than 20 µm.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic perspective view illustrating a method of cutting out a substrate from a nitride semiconductor crystal ingot by means of wire electrical discharge machining in an embodiment of the present invention.
Fig. 2 is a schematic block diagram illustrating an example of an overall structure of a wire electrical discharge machine.
Fig. 3 is a schematic block diagram illustrating an example of an overall structure of an electrical discharge machine in the case that electrical discharge machining is applied to form a curved surface.

### DESCRIPTION OF THE PREFERRED EMBODIMENTS

As described above, in a typical process of producing a semiconductor substrate, a crystal ingot is grown and then a peripheral portion thereof having low crystalline quality is removed by grinding or with a core drill. Thereafter, the ingot is cut to obtain a slice having a desired thickness. A cut-surface of the slice is polished and etched to be flat whereby removing a work-affected layer, and then the slice is cleaned to remove impurities on the cut-surface.

For Si, GaAs or the like, an ingot thereof is cut using an inner diameter blade or a wire saw. However, a nitride semiconductor crystal is liable to cause cracks because of its high hardness and low toughness, and since it contains two elemental components, it is difficult to perform linear cutting on an ingot thereof due to distribution of the hardness. While it is effective to perform cutting at low speed with reduced cutting load in order to suppress generation of cracks, it leads to reduction in throughput. Further, although it is also effective for the linear cutting to increase thickness of the tool in order to maintain strength of the tool, it requires an increased cutting allowance of the ingot and thus the resultant material yield rate is reduced. Consequently, with the conventional mechanical cutting technique, it is difficult to simultaneously achieve satisfactory cutting quality and throughput for the nitride semiconductor crystal.

Under such circumstances, it has been found for the first time as a result of study by the inventors that satisfactory cutting quality, higher throughput, and lower costs for the nitride semiconductor crystal can both be achieved by means of electrical discharge machining. Specifically, cutting with a wire saw needs abrasive grains because it is a mechanical work, and thus it requires costs for the ancillary material. In contrast, electrical discharge cutting needs no abrasive grains because a workpiece is locally melted by local electrical discharge generated by applying voltage in water or oil having an adjusted electrical resistance.

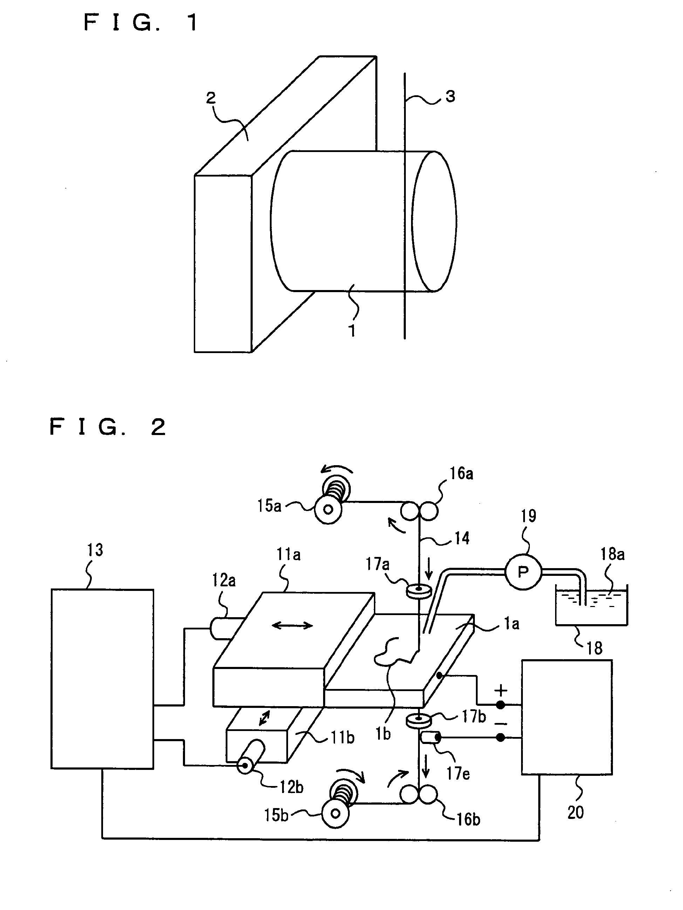

Fig. 1 is a schematic perspective view illustrating a method of cutting out a substrate from a nitride semiconductor crystal ingot by means of wire electrical discharge machining. As shown in the drawing, a nitride semiconductor crystal ingot 1 is fixed to a holder 2 and immersed in a cooling insulative medium such as deionized water or kerosene. Then, a wire electrode 3 comes close to ingot 1, and voltage is applied between wire electrode 3 and ingot 1. As a result, local and minute electrical discharge is generated between wire electrode 3 and ingot 1, and then cutting proceeds as the ingot material is locally removed by heat generated by the electrical discharge.

Since the material of wire electrode 3 is also consumed during the electrical discharge machining, the wire becomes thin at the electrical discharging portion. Accordingly, wire electrode 3 is moved in its longitudinal direction at a constant speed in order to be prevented from locally becoming thin and being broken during the electrical discharge machining. Further, wire 3 and ingot 1 are relatively moved by servo control such that wire 3 cuts into ingot 1 as the cutting proceeds.

Fig. 2 is a schematic block diagram illustrating an example of an overall structure of such a wire electrical discharge machine. This drawing illustrates the case where a relatively large workpiece is subjected to wire electrical discharge machining. A workpiece 1a is fixed on cross tables 11a and 11b which can be driven in an X-axis direction and a Y-axis direction, respectively. An X-axis motor 12a is connected to the upper table 11a, and a Y-axis motor 12b is connected to the lower table 11b. X-axis motor 12a and Y-axis motor 12b are controlled by an NC (numerically controlling) device 13 which includes a servo circuit.

A through-hole is formed in workpiece 1a beforehand, and a wire electrode 14 is passed through the through-hole. Specifically, wire 14 is supplied from a supply roll 15a, runs through upper rollers 16a and an upper guide 17a, and then passes through workpiece 1a. Thereafter, wire 14 runs through a lower guide 17b and lower rollers 16b, and then it is wound onto a take-up roll 15b.

During electrical discharge machining, a working fluid 18a such as deionized water held in a working fluid tank 18 is supplied to a machining part via a pump 19. Incidentally, in the case that a workpiece is of a size capable of being immersed in a working fluid tank, the whole workpiece may be immersed in the working fluid tank having a device for purifying a working fluid. With the working fluid being supplied to the machining part, voltage from an electrical discharge power source 20 is applied between workpiece 1a and wire 14. The voltage from electrical discharge power source 20 is applied to wire 14 via a power feeder 17e.

As such, local and minute electrical discharge is generated between workpiece 1a and wire 14, and cutting of workpiece 1a proceeds. In this case, workpiece 1a can be moved freely in the X direction and in the Y direction by cross tables 11a and 11b, respectively, thereby forming an arbitrary curved cut-line 1b. To maintain stable electrical discharge machining, information on the electrical discharge between wire 14 and workpiece 1a is fed back to NC device 13 from electrical discharge power source 20, and then NC device 13 finely adjusts the applied voltage and the relative moving speeds of cross tables 11a and 11b with respect to wire 14, based on the information.

Incidentally, while one wire electrode can be used to perform one cutting work in a typical electrical discharge wire cutting machine as shown in Fig. 1, a plurality of cutting works can also be performed simultaneously by providing an electrifying mechanism to a well-known multi-wire saw for cutting out semiconductor substrates from an ingot.

Although a wire electrode having a larger diameter offers an improved cutting speed and enables linear cutting, it requires an increased cutting allowance. On the other hand, the wire electrode should be made of a material having good electrical conductivity and thermal conductivity, and the material can preferably be selected from brass, zinc-coated brass, or the like. For the wire electrode needing to have high strength, it is possible to preferably use a brass-coated iron wire, a tungsten wire, a molybdenum wire, or the like. In other words, it is preferable to use a wire having high tensile strength at high temperature in order to prevent breaking of the wire electrode.

Further, since the electrode (wire) is also partially melted during electrical discharge machining, an element(s) constituting the electrode adheres to a surface formed by the machining. This adhesion can be suppressed by using a high melting point metal such as tungsten or molybdenum for the electrode.

Examples of nitride semiconductor crystals include AlN, GaN, InN, and a mixed crystal thereof. These nitride semiconductor crystals can be grown by means of a sublimation method, an HVPE (halide vapor phase epitaxy), a melt method, or the like.

After a substrate is cut out from a nitride semiconductor ingot, quality of its cut-surface can be improved in terms of flatness, surface roughness, a work-affected layer, and the like by sweeping the cut-surface of the substrate again with the wire under a low load. With such improvements, necessary allowances for polishing and etching in later processes can be reduced, and it is even possible to omit a polishing process. It is of course possible to perform etching and polishing in later processes in order to improve surface roughness of the cut-surface and to remove a work-affected layer. Sweeping the cut-surface with the wire can be repeated a plurality of times until desired surface quality is obtained.

When a nitride semiconductor crystal grows, crystal growth with good crystalline quality can be seen in its central region, while there may be a portion of low crystalline quality in its peripheral region. Since residual stress is concentrated in the portion of low crystalline quality, cutting work is conventionally performed after removal of the peripheral region having low crystalline quality. In contrast, a mechanical load applied onto the crystal is so small in electrical discharge machining that cutting work can be performed with the portion of low crystalline quality being left in the peripheral region. While the crystal obtained by the cutting can be subjected to surface polishing and etching without removal of the portion having low crystalline quality, it may also be subjected to surface polishing and etching after the portion of low crystalline quality is removed as appropriate.

Further, when a nitride semiconductor crystal grows, its growing surface occasionally causes unevenness with a level difference of about 1 mm. A crystal having a surface level difference of less than 30 µm can be obtained by removing the unevenness on the grown surface by means of electrical discharge machining.

The crystal material subjected to electrical discharge cutting is not limited to a nitride semiconductor crystal, and any conductive crystal material can be cut by means of electrical discharge cutting. The method of the present invention can also be used to cut a material of high hardness such as diamond or SiC at high speed, suppressing cutting-loss and generation of a work-affected layer.

Generally, for an ingot of a Si crystal or a GaAs crystal, it is usual to remove its periphery by grinding. In this case, in a crystal such as a nitride semiconductor ingot having residual stress concentrated in its periphery, fracture is liable to occur when the periphery is ground. To deal with this problem, an inner portion can be hollowed out by a core drill, maintaining stress balance in the stress concentrated portion in the periphery during working. However, when the ingot has a length more than 10mm, it becomes difficult to supply a working fluid to a part to be worked, making it hard to advance work on the material. As a result, there arise problems such as occurrence of fracture and tool consumption.

In electrical discharge machining, on the other hand, the working fluid (cooling fluid) can readily be supplied because there may be a hole through which the wire electrode penetrates a crystal to be cut. Further, since electrical discharge machining can be performed using an inexpensive wire electrode and electric power and does not require abrasive grains and a grinding wheel, the crystal can be worked simply and inexpensively.

Further, the wire electrode can also be applied to a periphery of a substrate cut out from an ingot, with being inclined at a predetermined angle to a main surface of the substrate, to remove or round an edge of the periphery.

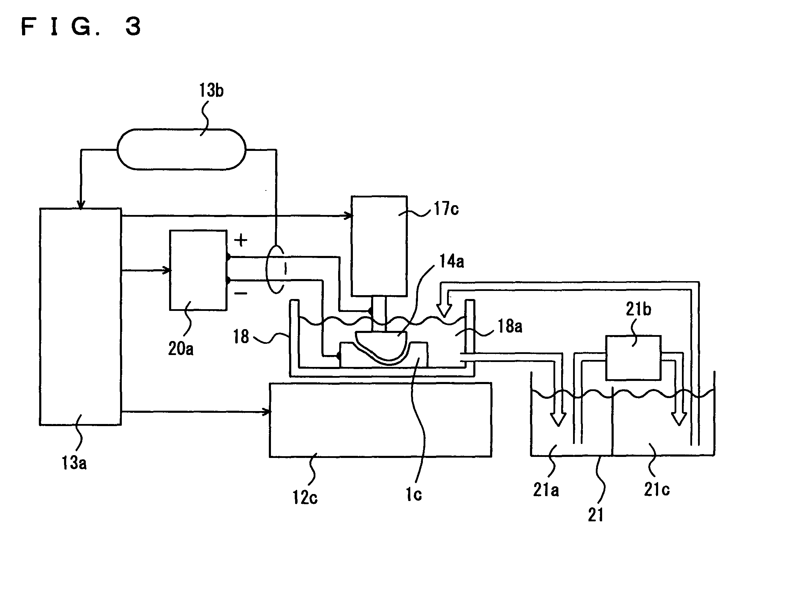

Fig. 3 is a schematic block diagram illustrating another example of the overall structure of the electrical discharge machine. While the electrical discharge machine of Fig. 3 is similar to that of Fig. 2, Fig. 3 illustrates the case of electrical discharge machining to form a surface geometry.

In Fig. 3, a working fluid tank 18 containing a working fluid 18a rests on an XY stage 12c. A workpiece 1c is immersed in working fluid 18a. An NC device 13a controls XY stage 12c as well as a Z-axis drive unit 17c. A working electrode 14a for forming a surface geometry (hereinafter referred to as a geographic working electrode) is attached to the lower end of Z-axis drive unit 17c.

Working fluid 18a in tank 18 circulates through a working fluid purifying apparatus 21. Specifically, working fluid 18a from tank 18 is stored in a first bath 21a of working fluid purifying apparatus 21, and then transferred to a second bath 21 c through a filtering device 21b. Thereafter, purified working fluid 18a is returned from the second bath 2 1 c to working fluid tank 18.

Voltage from an electrical discharge power source 20a is applied between workpiece 1c within working fluid tank 18 and geographic working electrode 14a. Then, local and minute electrical discharge is generated between workpiece 1c and geographic working electrode 14a, and then geographic working on workpiece 1c proceeds. In this case, information 13b on the electrical discharge between workpiece 1c and geographic working electrode 14a is fed back to NC device 13a, and the distance between workpiece 1c and geographic working electrode 14a as well as the voltage applied are finely adjusted based on the information.

In such geographic electrical discharge machining, working can be performed along any curved surface. It is needless to say that planar working can also be performed using a flat planar electrode.

### First Example

In a first example of the present invention, electrical discharge cutting was performed on a gallium nitride crystal having a diameter of 50 mm and a thickness of 30 mm grown by HVPE. This crystal contained oxygen as a dopant, and it had a carrier concentration of 4 × 10¹⁸ cm⁻³ and an electrical resistance of 1 × 10⁻² Ωcm. As shown in Fig. 1, crystal 1 was fixed to metal holder 2 with a conductive adhesive, and metal holder 2 was clamped to an electrical discharge machining apparatus. Wire electrode 3 of tungsten having a diameter of 0.1 mm was used (TWS-100 manufactured by Sumiden Fine Conductors). Cutting was performed on the crystal immersed in insulating water adjusted to have an electrical resistance of 70000 Ω. The wire was fed at a speed of 12 m/min, a working current was set at a value of 7, and a working voltage was set at 60 V. It took five hours to complete cutting under a constant electrical discharge condition with feeding-back of the voltage.

A substrate cut out had a thickness of 500 µm, and a cutting-loss as a width of a cutting groove was 140 µm. In addition, the substrate cut out had a warp of 12 µm. Further, the cut-surface of the substrate had a surface roughness Ra of 420 nm and a surface roughness Ry of 4700 nm.

Specifically, the surface roughness Ra is a value obtained by sampling a 10 µm x 10 µm square as a reference area from a rough curved surface to be measured along its mean surface, summing absolute values of deviations from the mean surface to the curved surface in the sampled section, and taking an average of the sum with the reference area. The surface roughness Ry is a value obtained by sampling a 10 µm x 10 µm square as a reference area from a rough curved surface along its mean surface, and summing a height from the mean surface to the highest peak and a depth from the mean surface to the deepest valley in the sampled area. Incidentally, the flatness means the sum of a height of the highest point and a depth of the deepest point in a direction perpendicular to a reference surface in the whole area to be measured in a sample.

### Second Example

In a second example of the present invention, cutting was performed under similar conditions as those in the first example, except that a molybdenum wire having a diameter of 0.1 mm (TM-100 manufactured by Sumiden Fine Conductors) was used as the wire electrode. It also took five hours to complete cutting in the second example.

A substrate cut out had a thickness of 500 µm, and the cutting-loss as the width of the cutting groove was 150 µm. In addition, the substrate cut out had a warp of 15 µm. Further, the cut-surface of the substrate had a surface roughness Ra of 480 nm and a surface roughness Ry of 5200 nm.

### Third Example

A third example of the present invention was different from the first example only in that a brass wire having a diameter of 0.15 mm (SS-15HN manufactured by Sumiden Fine Conductors) was used as the wire electrode and that cutting was performed with a working current set at a value of 11 and a working voltage set at 60 V. In the third example, it took two hours to complete cutting, enabling cutting in a short period of time. On the other hand, since the wire electrode used in the third example had a larger diameter than that in the first example, the cutting-loss increased to 190 µm.

### First Comparative Example

As a first comparative example, cutting was performed on the same gallium nitride crystal as that in the first example, using a multi-wire saw apparatus. A piano wire of 0.16 mm diameter was used as a wire saw, and diamond particles were used as abrasive grains. In the first comparative example, it took as much as 60 hours to complete cutting, and the cutting-loss was 200 µm. In the case that cutting was performed under conditions for completing cutting in 10 hours in consideration of a possibility of high-speed cutting with a wire saw, when the wire saw passed in the vicinity of the center of the ingot, its cutting length and mechanical load increased, causing generation of cracks in a substrate cut out. Consequently, it was not possible to perform satisfactory cutting.

### Fourth Example

In a fourth example of the present invention, wet etching was performed on the GaN substrate cut out in the third example. The substrate was immersed in an etching fluid which is a KOH solution having two-normal concentration heated at 50°C, in order to remove the N side surface of the GaN crystal by a thickness of 5 µm. Since the Ga side surface of the GaN crystal has high chemical durability, it was not etched enough to be confirmed in terms of thickness. Although the substrate before the etching had a warp of 20 µm due to a work-affected layer therein formed by electrical discharge machining, the warp of the substrate was improved to 10 µm after the work-affected layer was removed by the etching.

Further, the etched substrate was attached to a polishing holder and then polished by a lapping machine of a dead weight type. Diamond slurries containing particles of 6 µm and 2 µm diameters were used as polishing agents, and a copper surface plate and a tin surface plate were used as surface plates, respectively. A mirror surface was obtained after such polishing. The surface roughness Ra and the surface roughness Ry of the Ga side surface were reduced from 480 nm and 5300 nm before the polishing to 4.5 nm and 50 nm after the polishing, respectively. Consequently, the surface roughness after the polishing was smoothed to one percent of the surface roughness before the polishing.

### Fifth Example

In a fifth example of the present invention, cutting was performed on a gallium nitride crystal under the same conditions as those in the first example, and then a cut-surface of the substrate was swept again with the wire electrode under a low load in oreder to thinly remove the crystal surface on the cut-surface. In this case, the cut-in amount of the wire was set at 5 µm, the working electric current was set at a value of 4, and the working voltage was set at 50 V. With such wire sweeping, the surface roughness of the cut-surface of the substrate was smoothed to a surface roughness Ra of 120 nm and a surface roughness Ry of 1400 nm.

### Sixth Example

In a sixth example of the present invention, a gallium nitride crystal of 54 mm diameter and 30 mm thickness was grown by HVPE on a GaAs substrate of 50 mm diameter. Since the gallium nitride crystal grows also in a lateral direction extending from the base GaAs substrate, the grown crystal included a portion of low crystalline quality with a width of about 2 mm in its peripheral region.

Electrical discharge machining was performed in kerosene using a needle-like copper-tungsten electrode (Cu:W=30:70) of 1 mm diameter to form a through-hole near the periphery of the gallium nitride crystal. A brass wire of 0.2 mm diameter was passed through the through-hole to perform electrical discharge machining. A peripheral portion of the nitride semiconductor crystal was removed, and then the nitride semiconductor crystal was cut to obtain a disk-shaped crystal of 50 mm diameter having good crystalline quality.

### Second Comparative Example

In a second comparative example, peripheral grinding was performed on the same gallium nitride crystal (of 54 mm diameter and 30 mm thickness) as that in the sixth example. More specifically, a vitrified bonded diamond wheel was used, and grinding was performed under a condition that the wheel was rotated at 500 rpm. In this second comparative example, while the peripheral portion of low crystalline quality was being ground and removed, cracks were generated in the nitride semiconductor crystal due to large internal stress in the crystal. Consequently, it was not possible to obtain a disk-shaped crystal from the portion having good crystalline quality.

### Seventh Example

In a seventh example of the present invention, electrical discharge machining was performed on the crystal of 50 mm diameter subjected to the peripheral grinding in the sixth example, in order to remove unevenness on the cut-surface and thus smooth the cut-surface. Electrical discharge machining was performed in kerosene using a copper-tungsten electrode having a flat circular working surface with a surface roughness Ry of 1 µm, a flatness of 5 µm, and a diameter of 60 mm. Although the cut-surface of the substrate had unevenness of 500 µm before the electrical discharge machining, a smooth surface with a surface roughness Ry of 8.5 µm and a flatness of 15 µm was obtained by the machining.

### Eighth Example

In an eighth example of the present invention, electrical discharge cutting was performed on a Si-doped gallium nitride crystal synthesized by HVPE. Firstly, a gallium nitride crystal of 58 mm diameter and 5 mm thickness was grown on a GaAs substrate of 54 mm diameter. In this case, a portion of low crystalline quality was formed within a thickness range of about 2 mm from the ingot periphery by lateral growth of the crystal. Further, the grown surface of the ingot had unevenness with a level difference of about 1 mm.

Electrical discharge machining was performed on the nitride semiconductor crystal ingot in purified water, using a brass wire of 0.2 mm diameter. In this case, cutting was performed in a direction perpendicular to a direction in which the ingot has grown.

As a result, from the ingot including the portion of low crystalline quality in its peripheral region, it was possible to cut out a substrate of 0.5 mm thickness including the portion of low crystalline quality in the peripheral region. In this case, it took two hours to complete cutting, and the cutting-loss had a width of 0.28 mm that causes no problem. Five substrates were able to be cut out by repeating the same cutting operation. The cut-surfaces of the obtained substrates had unevenness of level differences less than 30 µm. Consequently, by thinly slicing a grown surface of an ingot, the ingot can be shaped into an ingot in which unevenness on its surface is set to have a level difference less than 30 µm.

### Third Comparative Example

In a third comparative example, cutting was performed by using a wire saw on such an ingot including a portion of low crystalline quality in its peripheral region as in the eighth example. In this case, a bonded abrasive wire including bonded diamond abrasive grains was used, and the wire had a diameter of 0.25 mm. It took 45 hours to complete cutting, and the cutting-loss had a width of 0.3 mm. In the case that cutting was performed under conditions for completing cutting in 15 hours, cracks were generated in the peripheral region during cutting the portion of low crystalline quality in the peripheral region. Consequently, it was not possible to perform satisfactory cutting.

As described above, the present invention can provide a technique of working a nitride semiconductor crystal in a simple and efficient manner at low costs. It is thereby possible to improve production efficiency of various semiconductor devices fabricated using nitride semiconductor crystals and then reduce production costs.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of working a nitride semiconductor crystal, wherein, when a nitride semiconductor crystal (1) is worked, voltage is applied between said crystal and a tool electrode (3) to cause electrical discharge, so that said crystal is partially removed and worked by local heat generated by the electrical discharge.

2. The method of working a nitride semiconductor crystal according to claim 1, wherein said crystal is cut using a wire electrode as said tool electrode.

3. The method of working a nitride semiconductor crystal according to claim 2, wherein said wire electrode is made of tungsten or molybdenum.

4. The method of working a nitride semiconductor crystal according to claim 2, wherein a nitride semiconductor crystal substrate is obtained by cutting an ingot of said nitride semiconductor crystal.

5. The method of working a nitride semiconductor crystal according to claim 2, wherein, after said cutting of said crystal, a surface formed by said cutting is smoothed by sweeping said surface again with said wire electrode.

6. The method of working a nitride semiconductor crystal according to claim 2, wherein said crystal substrate obtained by said cutting is etched.

7. The method of working a nitride semiconductor crystal according to claim 2, wherein said crystal substrate obtained by said cutting is polished.

8. The method of working a nitride semiconductor crystal according to claim 2, wherein a peripheral region of an ingot of said nitride semiconductor crystal includes a portion having low crystalline quality as compared to an inside thereof, and the ingot including said portion of low crystalline quality is cut in a direction perpendicular to a direction in which the ingot has grown.

9. The method of working a nitride semiconductor crystal according to claim 2, wherein unevenness on a grown surface of an ingot of said nitride semiconductor crystal is removed to obtain an ingot having a surface with unevenness of less than 30 µm.

10. The method of working a nitride semiconductor crystal according to claim 2, wherein an ingot of said nitride semiconductor crystal is cut so as to separate a peripheral portion thereof having low crystalline quality from a good crystal portion inside said ingot.

11. The method of working a nitride semiconductor crystal according to claim 10, wherein a through-hole is formed in said ingot and then said wire electrode is passed through said through-hole to make said through-hole a starting point for cutting, in order to take out the good crystal portion inside said ingot without working the peripheral portion having low crystalline quality.

12. The method of working a nitride semiconductor crystal according to claim 2, wherein, after a substrate is cut out from an ingot of said nitride semiconductor crystal, an edge at an end of a surface of said substrate is removed by inclining a longitudinal direction of said wire electrode at an angle in a range of 0-60° from a direction perpendicular to said surface of said substrate.

13. The method of working a nitride semiconductor crystal according to claim 1, wherein a desired surface geometry is formed on said crystal by transferring a surface geometry of said tool electrode to said crystal.

14. The method of working a nitride semiconductor crystal according to claim 13, wherein unevenness on a surface of said crystal is removed to obtain a smooth surface having a surface roughness Ry of less than 10 µm and a flatness of less than 20 µm, by using said tool electrode having a surface roughness Ry of less than 10 µm and a flatness of less than 20 µm.
